Europäisches Patentamt

European Patent Office

Office européen des brevets

(11) Veröffentlichungsnummer: **0 057 239**
**B1**

# EUROPÄISCHE PATENTSCHRIFT

(45) Veröffentlichungstag der Patentschrift:
13.02.85

(21) Anmeldenummer: 81100662.6

(22) Anmeldetag: 30.01.81

(51) Int. Cl.⁴: **H 03 K 17/16,** H 03 K 6/02,
H 03 K 19/003

(54) **Monolithisch integrierte Gegentakt-Treiberschaltung.**

(43) Veröffentlichungstag der Anmeldung:
**11.08.82 Patentblatt 82/32**

(45) Bekanntmachung des Hinweises auf die Patenterteilung:
**13.02.85 Patentblatt 85/7**

(84) Benannte Vertragsstaaten:
**DE FR GB IT**

(56) Entgegenhaltungen:
**ELECTRO/80 CONFERENCE RECORD, Band 5, 13.-15. Mai 1980, Boston MA, T.S. JEN et al. "Gate Array Experiences in IBM", Seiten 1 bis 8**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT**

(72) Erfinder: **Miersch, Ekkehard, Dr., Dresdner Strasse 6, D-7036 Schönaich (DE)**
Erfinder: **Pollmann, Kurt, Ulmenweg 21, D-7031 Aitdorf (DE)**
Erfinder: **Schettler, Helmut, Jägerstrasse 23, D-7405 Dettenhausen (DE)**
Erfinder: **Zühlke, Rainer, Dr., Rainstrasse 3, D-7250 Leonberg 7 (DE)**

(74) Vertreter: **Neuland, Johannes, Dipl.-Ing., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine monolithisch integrierte Gegentakt-Treiberschaltung mit verringerter Störspannungserzeugung auf der Masseleitung beim Schalten in den niedrigen Ausgangspegel.

Durch die bei der Herstellung monolithisch integrierter Halbleiterschaltungen erzielten technologischen Fortschritte können die für ein Datenverarbeitungssystem benötigten Schaltkreise auf den Halbleiterchips mit immer kleineren Abmessungen realisiert werden. Dadurch lassen sich mehr Schaltkreise auf der gleichen Fläche herstellen. Durch die höher werdende Integrationsdichte steigt auch die Anzahl der Ausgangsleitungen eines Halbleiterchips und damit die Zahl der für sie benötigten Treiberschaltungen. Im Interesse einer schnellen Verarbeitung der Daten müssen diese im Parallelbetrieb verarbeitet werden. Dies bedeutet, daß eine Reihe von Treiberstufen gleichzeitig geschaltet werden muß. Dabei entsteht jedoch aufgrund der Induktivität des Leiterzuges, über den das Halbleiterchip mit der Masse-Ebene in der das Halbleiterchip tragenden Schaltkarte verbunden ist, das Problem der Störspannungserzeugung auf der Masseleitung des Halbleiterchips. Da diese Störspannung auch Speicherglieder beeinflußt, die in der Nähe der Treiberschaltungen angeordnet sind und der Speicherung von Verknüpfungsergebnissen logischer Schaltungen dienen, muß dafür Sorge getragen werden, daß diese Störspannung kleiner bleibt als die Schaltschwelle der Speicherglieder, andernfalls wird deren Zustand in unerwünschter Weise durch die Störspannung geändert. Eine Möglichkeit, die Störspannung zu verringern besteht, wie dem Aufsatz »Gate Array Experiences in IBM« von T. S. Jen et al. im Band 5 der Veröffentlichung »Electro/80 Conference Record«, May 13—15, 1980 Boston MA, zu entnehmen ist, darin, die beim Schalten der Treiberstufe auftretende Stromänderung der Zeiteinheit durch eine Rückkopplung vom Ausgang der Treiberschaltung auf ihren Eingang zu verringern. Da die Größe der Störspannung u. a. auch von der Anzahl der gleichzeitig schaltenden Treiberstufen abhängt, besteht eine andere Möglichkeit, die Störspannung klein zu halten darin, diese Anzahl zu begrenzen.

Diese zeitlich gestaffelte Schalten verringert jedoch die Geschwindigkeit der Datenübertragung.

Hier will die Erfindung Abhilfe schaffen. Die Erfindung, wie sie in den Ansprüchen gekennzeichnet ist, löst die Aufgabe, eine monolithisch integrierte Gegentakt-Treiberschaltung zu schaffen, die beim Schalten in den niedrigen Ausgangspegel eine verringerte Störspannung auf der Masseleitung erzeugt.

Die durch die Erfindung erreichten Vorteile sind im wesentlichen darin zu sehen, daß aufgrund der verringerten Störspannung der Treiberstufe eine Begrenzung der Anzahl der gleichzeitig schaltenden Treiberstufen nicht mehr erforderlich ist und damit auch ein zeitlich gestaffeltes Schalten mehrerer Gruppen von Treiberstufen, die innerhalb einer Gruppe gleichzeitig schalten, nicht mehr erforderlich ist. Damit erhöht sich aber die Geschwindigkeit der Datenübertragung.

Im folgenden wird die Erfindung anhand zweier Ausführungsbeispiele in Verbindung mit den Zeichnungen näher erläutert. Es zeigt

Fig. 1 das Schaltbild einer üblichen Gegentakt-Treiberstufe,

Fig. 2 das Schaltbild einer Gegentakt-Treiberschaltung mit einer Störspannungs-Begrenzerschaltung nach der Erfindung,

Fig. 3 das Schaltbild einer vereinfachten Gegentakt-Treiberausgangsstufe nach der Erfindung,

Fig. 4 den zeitlichen Verlauf der Störspannung $u_n$ und des sie hervorrufenden Stromes I für die Schaltung nach Fig. 1 und

Fig. 5 den zeitlichen Verlauf der Störspannung $u_n$ und des sie hervorrufenden Stromes I bei der erfindungsgemäßen Treiberschaltung.

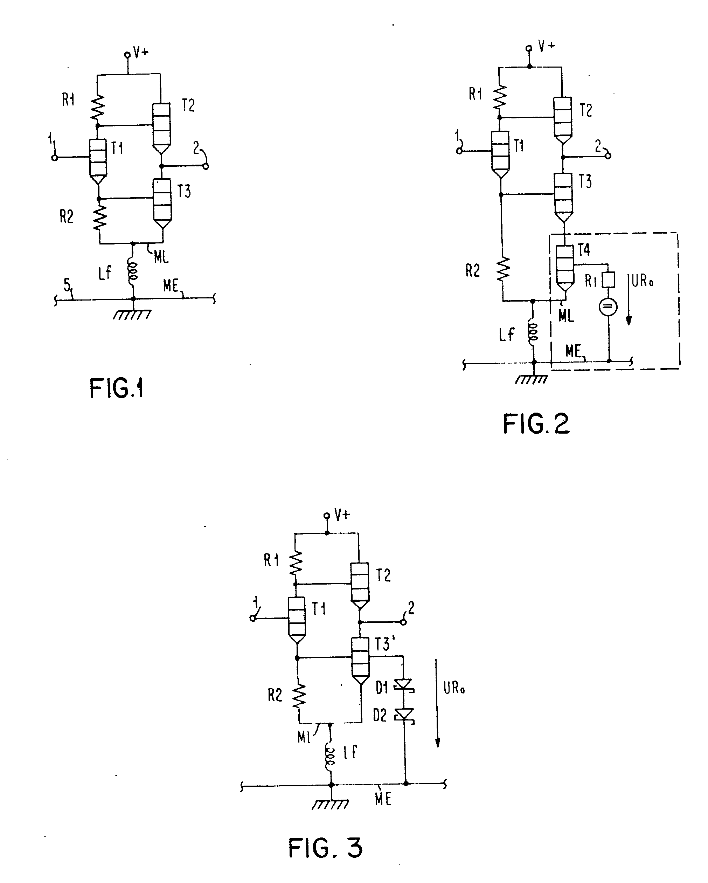

In Fig. 1 ist das Schaltbild der Ausgangsstufe einer üblichen monolithisch integrierten Gegentakt-Treiberschaltung nach dem Stand der Technik dargestellt. Mit Lf ist dabei die Induktivität der Verbindungsleitung angedeutet, über die die Masseleitung ML auf dem Halbleiterchip über einen Leiterzug auf dem Chipsubstrat und einen metallischen Verbindungsstift mit der Masse-Ebene ME einer Schaltkarte verbunden ist, die den aus dem Halbleiterchip, dessen Substrat und einer Abdeckhaube gebildeten Modul aufnimmt. Die Wirkungsweise dieser bekannten Gegentakt-Treiberschaltung ist folgende:

Wenn der Eingangsklemme 1 ein niedriger Spannungspegel zugeleitet wird, ist der Transistor T1 gesperrt. Daher erhält der Transistor T3 keinen Basisstrom von dem Transistor T1 mehr und sperrt ebenfalls. Jetzt fließt jedoch über den Widerstand R1 Strom in die Basis des Transistors T2. Dieser Transistor ist daher leitend und am Ausgang 2 der Gegentakt-Treiberschaltung ist ein hohes Potential vorhanden.

Wird ein hohes Potential an die Eingangsklemme 1 angelegt, wird der Transistor T1 leitend und entzieht dadurch dem Transistor T2 den Basisstrom, so daß dieser Transistor sperrt. Dafür erhält jetzt der Transistor T3 Basisstrom über den Transistor T1, so daß der Transistor T3 leitend wird, während der Transistor T2 gesperrt ist. Durch den leitenden Transistor T3 stellt sich am Ausgang 2 der Gegentakt-Treiberschaltung ein niedriges Potential ein. Der beim Leitendwerden des Transistors T3 in diesem erfolgende Stromanstieg ruft in der Induktivität Lf, die im wesentlichen durch einen Anschlußstift gebildet wird, über den die Massseleitung ML von Chip und Chipsubstrat mit der Masse-Ebene ME in der Schaltkarte verbunden ist, eine Störspannung $u_n$ auf der Masseleitung ML des Halbleiterchips hervor. Diese Störspannung ist umso größer, je größer die Stromänderung pro Zeiteinheit ist. Wenn daher bei einer Reihe von auf dem Halbleiterchip angeordneten Gegentakt-Treiberschaltungen mehrere, im Extremfall alle Transistoren T3 gleichzeitig leitend gemacht werden, fließt ein hoher Einschalt-Summenstrom über die allen Treiberschaltungen gemeinsame Induktivität Lf, so daß auf der Masseleitung ML eine entsprechend hohe Störspannung $u_n$ auftritt. Die Größe dieser Störspannung $u_n$ berechnet sich aus der Beziehung:

$$u_n = -L \frac{\Delta I}{\Delta t}.$$

Je nach der Anzahl der gleichzeitig leitend werdenden Transistoren T3 erreicht die Störspannung eine solche Größe, daß Speicherglieder, die sich in der Nähe der Gegentakt-Treiberschaltungen befinden, aufgrund einer Beeinflussung durch die Störspannung ihren gespeicherten Zustand ändern und statt des gewünschten Binärwertes den entgegengesetzten speichern.

In Fig. 2 ist das Schaltbild der erfindungsgemäßen Ausgangsstufe einer Gegentakt-Treiberschaltung dargestellt, bei der die durch Einschalten des Transistors T3 entstehende Störspannung $u_n$ stark verringert ist. Das Schaltbild unterscheidet sich von dem nach Fig. 1 durch einen zwischen die Masseleitung ML des Halbleiterchips und den Emitter des Transistors T3 eingefügten weiteren Transistor T4. Dessen Basis ist mit dem positiven Pol einer Referenz-Gleichspannungsquelle $UR_0$, die den Innenwiderstand Ri besitzt, verbunden, deren negativer Pol mit der Masse-Ebene ME der Schaltkarte verbunden ist. Die Spannung der Referenz-Gleichspannungsquelle $UR_0$ ist so gewählt, daß der Transistor T4 im Gleichstrombetrieb voll leitend ist. Die Schaltung nach Fig. 2 arbeitet in folgender Weise: Sobald beim gleichzeitigen Leitendwerden mehrerer der Transistoren T3 an der Induktivität Lf infolge der zeitlichen Änderung des zur Masse-Ebene fließenden Stromes I eine positive, gegen Masse gerichtete Störspannung $u_n$ entsteht, wird das Emitterpotential des Transistors T4 angehoben, während sein Basispotential durch die Referenz-Gleichspannungsquelle auf deren Wert festgehalten wird. Dadurch verringert sich die Basis-Emitterspannung des Transistors T4. Dieser Transistor wirkt weniger gut leitend, d. h., sein Widerstand erhöht sich und er wirkt daher dem Anstieg des vom Transistor T3 gelieferten Stromes I entgegen. Der Stromanstieg wird somit verlangsamt. Damit wird aber auch die Größe der Störspannung verringert, da ihr Wert der zeitlichen Änderung des vom Transistor T3 gelieferten Stromes proportional ist. Die Beziehung zwischen der maximal tolerierbaren Störspannung $u_n$ und der Referenz-Gleichspannung $UR_0$ ist durch die Beziehung gegeben

$$u_n \leq UR_0 - U_{BE(T4)}.$$

Für eine einwandfreie Funktion der Schaltung ist es erforderlich, daß der Innenwiderstand Ri der Referenz-Gleichspannungsquelle $UR_0$ einen genügend hohen Wert aufweist, um deren Strom in die Basis des Transistors T4 zu begrenzen.

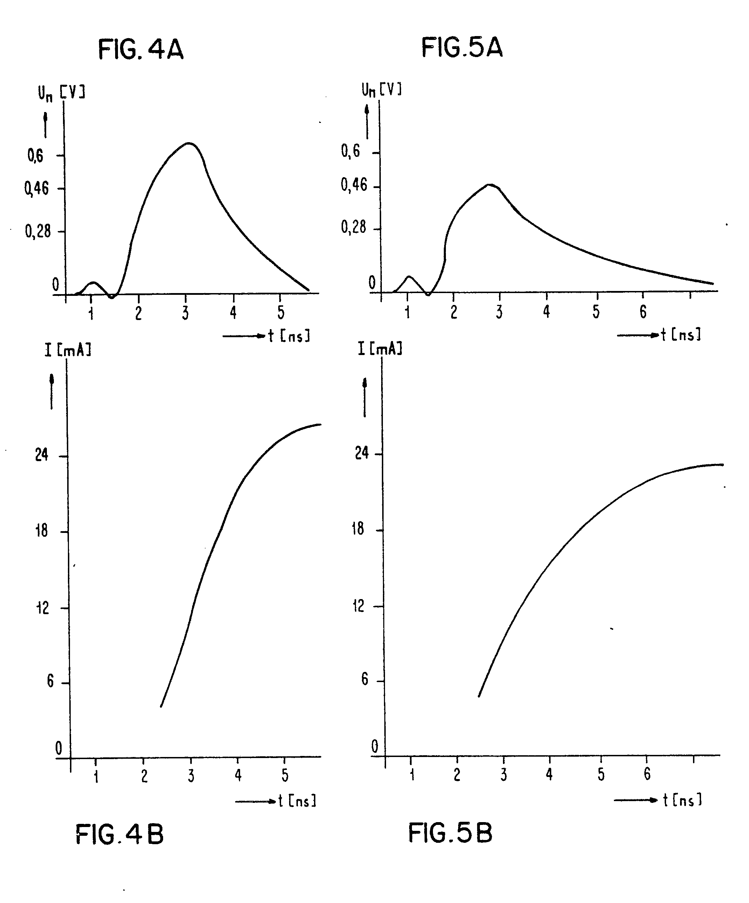

In Fig. 4 ist die bei einer üblichen Gegentakt-Treiberschaltung beim Leitendwerden des Transistors T3 auf der Masseleitung ML entstehende Störspannung $u_n$ und der sie hervorrufende zeitliche Verlauf des Stromes I dargestellt.

Fig. 5 zeigt zum Vergleich die bei einer Gegentakt-Treiberschaltung gemäß der Erfindung entstehende Störspannung und den zeitlichen Verlauf des sie herrufenden Stromes I. Der Vergleich der beiden Figuren 4 und 5 zeigt, daß bei der erfindungsgemäßen Gegentakt-Treiberschaltung die Störspannung $u_n$ aufgrund des verlangsamten Stromanstieges des Transistors T3 nur die Hälfte des Wertes beträgt, der bei der Schaltung nach Fig. 1 auftritt.

Fig. 3 zeigt eine vereinfachte Gegentakt-Treiberschaltung, bei der die Transistoren T3 und T4 der Schaltung nach Fig. 2 zu einem Transistor T3' zusammengefaßt sind, an dessen Basis auch der positive Pol der Referenz-Gleichspannungsquelle $UR_0$ angeschlossen ist, die bei diesem Ausführungsbeispiel durch zwei in Reihe geschaltete Schottky-Dioden realisiert ist. Die Wirkungsweise dieser Gegentakt-Treiberschaltung ist die gleiche wie die der in Verbindung mit Fig. 2 beschriebenen.

Aufgrund der verringerten Störspannung der erfindungsgemäßen Gegentakt-Treiberschaltung können bei einem vorgegebenen Wert der maximal zulässigen Störspannung $u_n$ mehr Treiberstufen gleichzeitig in den niedrigen Ausgangspegel schalten, als das bisher möglich war. Damit kann auf ein zeitlich gestaffeltes Schalten von gruppenweise zusammengefaßten, innerhalb der Gruppe gleichzeitig schaltenden Gegentakt-Treiberschaltungen verzichtet werden, was zu einer Erhöhung der Datenübertragungsgeschwindigkeit führt. Um die Beeinflussung von den Gegentakt-Treiberschaltungen benachbarten Speichergliedern weiter zu verringern, wird für die Gegentakt-Treiberschaltungen eine gesonderte Masse-Leitung ML und eine gesonderte Verbindung dieser Leitung mit der Masse-Ebene ME der Schaltkarte vorgesehen.

**Patentansprüche**

1. Monolithisch integrierte Gegentakt-Treiberschaltung mit verringerter Störspannungserzeugung auf der Masseleitung beim Schalten in den niedrigen Ausgangspegel, dadurch gekennzeichnet, daß zwischen dem Emitter des bei niedrigem Ausgangspegel leitenden Ausgangstransistors (T3) und der Masseleitung (ML) ein weiterer Transistor (T4) eingefügt ist, dessen Basis an den einen Pol einer Referenz-Gleichspannungsquelle (UR$_0$) angeschlossen ist, deren zweiter Pol mit der Masse-Ebene (ME) einer Schaltkarte verbunden ist, auf der das die Gegentakt-Treiberschaltung enthaltende Halbleiterchip über ein Chipsubstrat befestigt ist.

2. Monolithisch integrierte Gegentakt-Treiberschaltung mit verringerter Störspannungserzeugung auf der Masseleitung beim Schalten in den niedrigen Ausgangspegel, dadurch gekennzeichnet, daß die Basis des bei niedrigem Ausgangspegel leitenden Ausgangstransistors (T3) außer mit dem Emitter des Eingangstransistors (T1) der Gegentakt-Treiberschaltung noch mit dem einen Pol einer Referenz-Gleichspannungsquelle (UR$_0$) verbunden ist, deren zweiter Pol an die Masse-Ebene (ME) der Schaltkarte angeschlossen ist.

3. Monolithisch integrierte Gegentakt-Treiberschaltung nach den Ansprüchen 1 oder 2, dadurch gekennzeichnet, daß die Referenz-Gleichspannungsquelle UR$_0$ durch eine Reihenschaltung von Schottky-Dioden (D1, D2) realisiert ist.

4. Monolithisch integrierte Gegentakt-Treiberschaltung nach den Ansprüchen 1 bis 3, dadurch gekennzeichnet, daß für die Gegentakt-Treiberschaltung eine gesonderte Masse-Ebene (ME) der Schaltkarte vorgesehen ist.

## Claims

1. Monolithically integrated push-pull driver circuit which when switched to the low output level generates a reduced noise voltage at the ground line, characterized in that between the emitter of the output transistor (T3), which becomes conductive at the low output level, and the ground line (ML) a further transistor (T4) is provided whose base is connected to one pole of a reference DC voltage source (UR$_0$) having its second pole connected to the ground plane (ME) of a circuit card to which the semiconducteur chip comprising said push-pull driver circuit is fixed by means of a chip substrate.

2. Monolithically integrated push-pull driver circuit which when switched to the low output level generates a reduced noise voltage at the ground line, characterized in that the base of the output transistor (T3), which becomes conductive at the low output level, in addition to being connected to the emitter of the input transistor (T1) of the push-pull driver circuit, has one pole connected to a reference DC voltage source (UR$_0$) whose second pole is connected to the ground plane (ME) of the circuit card.

3. Monolithically integrated push-pull driver circuit according to claim 1 or 2, characterized in that the reference DC voltage source (UR$_0$) is realized by series-connected Schottky diodes (D1, D2).

4. Monolithically integrated push-pull driver circuit according to claims 1 to 3, characterized in that a separate ground line (ML) and a separate connection to the ground plane (ME) of the circuit card are provided for the push-pull driver circuit.

## Revendications

1. Circuit d'attaque du type push-pull monolithique intégré générant une tension parasite réduite dans la connexion à la masse lors de la commutation dudit circuit dans un niveau de sortie logique bas, caractérisé en ce qu'un transistor supplémentaire (T4) est disposé entre d'une part l'émetteur du transistor de sortie (T3) conducteur quand le niveau de sortie est bas et d'autre part la connexion à la masse (ML), la base dudit transistor (T4) étant connecté à un des poles d'une source de tension continue de référence (UR$_0$), l'autre pole étant relié au niveau à la masse (ME) d'une carte imprimée sur laquelle est fixée la microplaquette semiconductrice, montée sur un substrat, laquelle microplaquette contient ledit circuit d'attaque du type push-pull.

2. Circuit d'attaque du type push-pull monolithique intégré générant une tension parasite réduite à la connexion à la masse lors de la commutation dudit circuit dans un niveau de sortie bas, caractérisé en ce que la base dudit transistor de sortie (T3) conducteur, quand le niveau de sortie logique est bas, est connectée non seulement avec l'émetteur du transistor d'entrée (T1) du circuit d'attaque du type push-pull mais aussi avec le pole d'une source de tension continue de référence (UR$_0$) dont le second pole est reliée au potentiel de la masse (ME) de ladite carte imprimée.

3. Circuit d'atttaque du type push-pull monolithique intégré selon la revendication 1 ou 2, caractérisé en ce que la source de tension continue de référence UR$_0$ est réalisée par des diodes Schottky (D1, D2) montées en série.

4. Circuit d'attaque du type push-pull monolithique intégré selon les revendications 1 à 3, caractérisé en ce qu'il est prévu pour le circuit d'attaque du type push-pull une connexion à la masse (ML) séparée et une connexion particulière au potentiel de la masse (ME) de ladite carte imprimée.

FIG.1

FIG.2

FIG. 3

FIG. 4A

FIG.5A

FIG.4B

FIG.5B

7